Europäisches Patentamt

(19) European Patent Office

Office européen des brevets

(11) **EP 0 588 718 B1**

(12) **FASCICULE DE BREVET EUROPEEN**

(45) Date de publication et mention
de la délivrance du brevet:
**12.12.2001 Bulletin 2001/50**

(51) Int Cl.⁷: **C03C 3/32**, C03C 17/02,
C23C 14/24

(21) Numéro de dépôt: **93402247.6**

(22) Date de dépôt: **15.09.1993**

(54) **Procédé de dépôt en phase vapeur d'un film en verre fluoré sur un substrat**

Verfahren zur Abscheidung aus der Gasphase von einem Fluorid-Glasfilm auf einem Substrat

Process for the vapour phase deposition of a fluoride glass film on a substrate

(84) Etats contractants désignés:
**BE CH DE FR GB IT LI NL**

(30) Priorité: **18.09.1992 FR 9211158**

(43) Date de publication de la demande:
**23.03.1994 Bulletin 1994/12**

(73) Titulaire: **ALCATEL**
**75008 Paris (FR)**

(72) Inventeurs:
• **Jacoboni, Charles**
**F-72380 St Jamme (FR)**
• **Boulard, Brigitte**
**F-72100 Le Mans (FR)**

• **Perrot, Olivier**
**F-53000 Laval (FR)**

(74) Mandataire: **Laroche, Danièle et al**
**COMPAGNIE FINANCIERE ALCATEL**
**Dépt. Propriété Industrielle,**
**30, avenue Kléber**
**75116 Paris (FR)**

(56) Documents cités:
**EP-A- 0 309 117          EP-A- 0 500 122**
**WO-A-90/08743**

• **PATENT ABSTRACTS OF JAPAN vol. 12, no. 482**
**(C-553)(3329) & JP-A-63 199 860 (NEC CORP)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention concerne un procédé de dépôt en phase vapeur d'un verre fluoré sur un substrat. Les verres fluorés concernés sont décrits notamment dans le brevet français FR-A-2 452 469 et son premier certificat d'addition FR-A-2 479 797.

Ces verres fluorés ont la propriété de présenter une large fenêtre de transparence (longueurs d'ondes allant généralement de 0,3 à 8 micromètres) et en particulier une ultra-transparence dans l'infrarouge moyen, nettement supérieure à celle de la silice.

Le domaine d'application des verres fluorés peut donc s'étendre depuis les télécommunications à longues distances par fibres optiques à très faibles pertes, jusqu'aux fibres lasers pour la microchirurgie, et de manière générale, aux composants pour l'optique intégrée.

On sait que la préparation des fibres et des composants optiques nécessite des matériaux ayant une très grande pureté. En particulier, certains cations tels que le fer, le cobalt, le nickel, etc... ne doivent pas être présents à raison de plus de 10 à 50 parties par milliard. Les procédés classiques de fabrication des pièces de verre fluorés par fusion et trempe entraînent une pollution importante par le contact avec les récipients utilisés pour la fusion et le coulage. Il est donc très intéressant de pouvoir préparer des verres fluorés par dépôt en phase vapeur afin d'éviter de tels inconvénients.

Toutefois, les techniques usuelles de dépôt en phase vapeur sont difficilement utilisables en raison de la complexité chimique des systèmes vitreux fluorés. En effet, les verres fluorés comportent généralement au moins quatre constituants. Or, si la composition de la vapeur en équilibre au-dessus de mélanges binaires peut généralement être prévue, l'introduction d'autres constituants rend l'évaporation plus complexe et les rapports théoriques des constituants de la phase vapeur ne sont plus respectés. En général, le mélange fondu dans le creuset s'enrichit en un ou plusieurs constituants moins volatils que les autres, de sorte que la modification de la composition du liquide à évaporer conduit rapidement à sortir du domaine thermique du liquidus. On constate alors que l'évaporation s'arrête, et que la composition présente dans le creuset cristallise.

La demande de brevet internationale WO 90 08 743 montre qu'il est possible de déposer plus aisément en phase vapeur des compositions vitreuses fluorées, en fondant les constituants du verre à déposer dans un bain d'accueil constitué par un mélange fondu de fluorures formant lui-même une composition vitrifiable constituée d'éléments moins volatils que les fluorures du verre à déposer. Cette technique permet d'éviter les difficultés rencontrées dans la méthode d'évaporation directe, car on a découvert que la composition du "verre d'accueil" reste sensiblement constante, ou en tous cas varie suffisamment peu pour qu'il soit possible de maintenir le bain à l'état liquide.

Néanmoins, il subsiste encore un problème si l'on souhaite obtenir par dépôt en phase vapeur sur un substrat un film en verre fluoré fortement dopé en terres rares. Ainsi, si l'on introduit en outre dans le creuset des fluorures ou des halogénures de terres rares, il s'avère impossible d'obtenir un film de composition prédéterminée en terres rares.

La présente invention a pour but de proposer un procédé de dépôt en phase vapeur permettant de maitriser la composition d'un film en verre fluoré dopé en terres rares.

La présente invention a pour objet un procédé de dépôt en phase vapeur d'un film en verre fluoré sur un substrat, selon lequel on met en contact ledit substrat avec des flux de vapeurs des divers constituants dudit verre, lesdits flux de vapeur étant émis à partir d'un premier creuset contenant un bain d'accueil et les fluorures métalliques de base constituant ledit verre fluoré, caractérisé par le fait que lesdits flux de vapeur sont en outre émis de manière simultanée à partir d'un second creuset contenant des éléments dopants constitués par au moins deux halogénures dont au moins un halogénure de terres rares.

Selon un mode de réalisation préférentiel, ledit second creuset contient des éléments dopants répondant à la formulation :

$$xYX_3 + (1-x)LnX_3$$

avec : $o < x < 1$,

et Ln = La, Ce, Pr, Nd, Pm, Sm, Eu, Gd, Tb, Dy, Ho, Er, Tm, Yb, Lu,
Y = Yttrium,
X = F ou Cl,

$LnX_3$ représentant un halogénure de terre rare ou un mélange d'halogénures de terres rares.

Le contrôle des paramètres suivants permet à l'homme de l'art de choisir l'épaisseur du film de verre fluoré dopé déposé sur le substrat, ainsi que son taux de dopage en terres rares :

-    température de chaque creuset
-    durée d'évaporation pour chaque creuset

   -    positions relatives verticales et horizontales des creusets

-    positions du substrat dans la zone d'évaporation.

On atteint ainsi des épaisseurs de film allant de 1 micromètre à plusieurs dizaines de micromètres et des taux de dopage en halogénures de terres rares pouvant aller jusqu'à 15 % en mole de la composition du verre.

En cas de mélange de plusieurs terres rares ayant des propriétés thermodynamiques très différentes, il peut être avantageux de les répartir dans plusieurs "seconds" creusets différents que l'on fait fonctionner simultanément en vue de l'obtention d'un film de composition prédéterminée.

De préférence, le flux de vapeur émis par ledit premier creuset présente la composition suivante (en mole %; total 100 %) :

.    30 à 50        $PbF_2$
.    30 à 50        $GaF_3$ ou $FeF_3$ ou $CrF_3$
.    0 à 30        $ZnF_2$ ou $CuF_2$
.    1 à 5        $MnF_2$ ou $CdF_2$ ou $CoF_2$
.    1 à 5        $InF_3$
.    0 à 10        $AlF_3$
.    0 à 10        Adjuvant.

Il est prévu également, de préférence, que ledit premier creuset contienne un bain d'accueil ayant la composition suivante :

.    9 à 26        $YF_3$
.    19 à 28        $BaF_2$
.    35 à 40        $InF_3$
.    18 à 25        $MnF_2$ ou $CdF_2$ ou $ZnF_2$ ou $CoF_2$
.    0 à 10        Adjuvant.

La proportion initiale en masse du bain d'accueil par rapport à la masse totale du bain initial est suffisamment importante pour maintenir une composition stable du bain d'accueil. Cette proportion varie par exemple de 50 % à 90 %.

Certains constituants du bain d'accueil notamment $InF_3$, $MnF_2$, $CdF_2$, et éventuellement les adjuvants, se retrouvent en faibles proportions dans le verre fluoré déposé. Le fluorure de zinc peut faire partie du bain d'accueil, mais il se retrouve alors également, en proportions qui peuvent être relativement importantes (par exemple de 10 à 30 %), dans le verre déposé auquel il confère une stabilité accrue.

L'adjuvant éventuellement présent dans le bain d'accueil et dans le verre à déposer est notamment constitué par un ou plusieurs fluorures métalliques, en particulier des fluorures métalliques dont les métaux sont en coordination octaédrique, comme par exemple les éléments 3d de la classification périodique, ou encore des fluorures alcalins, par exemple NaF ou LiF.

Si l'on envisage de déposer successivement plusieurs films de verres fluorés de compositions de base différentes sur un même substrat, il est avantageux de prévoir dans la même enceinte d'évaporation plusieurs "premiers" creusets destinés à recevoir lesdites compositions différentes.

Le matériau dudit substrat est choisi par exemple parmi un verre fluoré, l'alumine, la silice, le carbone, un métal, le silicium, un matériau semi-conducteur comme par exemple InP ou GaAS.

Le substrat peut avoir une forme quelconque selon l'application envisagée ; il peut s'agir d'un cylindre, d'un tube creux destiné à la réalisation d'une préforme pour fibre optique ou d'une plaque destinée à la réalisation d'une structure guidante en optique intégrée.

D'autres caractéristiques et avantages de la présente invention apparaîtront au cours de la description suivante de modes de réalisation donnés à titre illustratif mais nullement limitatif. Dans le dessin annexé :

-    La figure 1 montre un schéma d'un dispositif d'évaporation pour la mise en oeuvre le procédé selon l'invention,

-    La figure 2 est une coupe schématique d'un composant optique pour l'optique intégrée résultant de la mise en oeuvre du procédé selon l'invention.

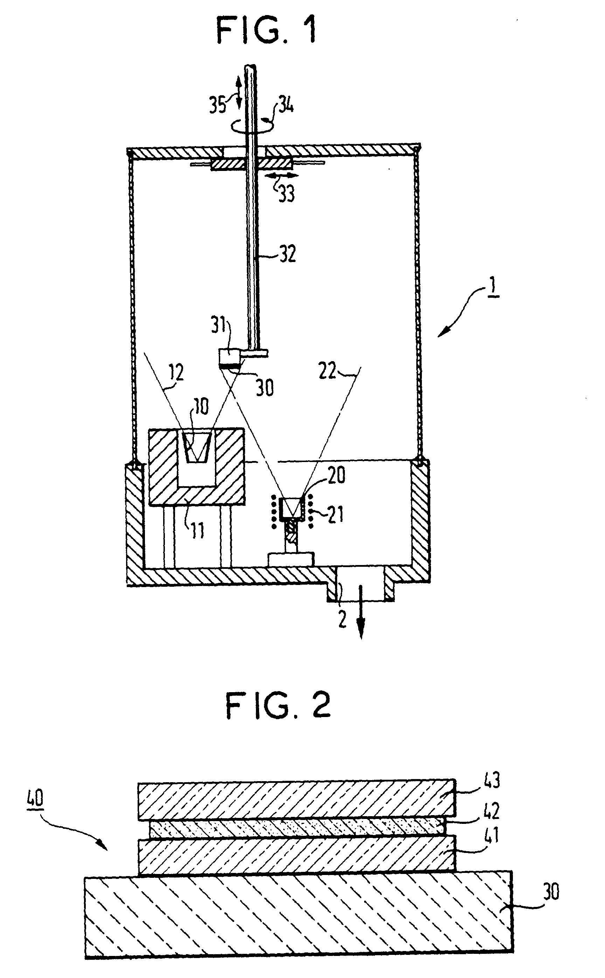

On voit dans la figure 1 un évaporateur 1, relié en 2 à une pompe à vide. Il contient un premier creuset 10 en platine et un second creuset 20 en carbone graphite. Chacun de ces creusets est disposé sur un support et chauffé par induction à l'aide d'un dispositif de chauffage haute fréquence schématisé en 11 et 21. Ces dispositifs 11 et 21 peuvent être commandés indépendamment l'un de l'autre.

Un substrat 30 disposé dans un porte-substrat 31 est disposé dans la zone commune des cônes 12 et 22 des flux émis par les deux creusets 10 et 20.

La position optimale substrat-creusets est réglable au niveau du bras support 32, suivant différents mouvements schématisés par les flèches 33, 34, 35.

Des caches (non illustrés) peuvent éventuellement être disposés au moins partiellement devant le substrat.

Dans tous les exemples ci-après les proportions sont données en mole (%) ou en grammes (g).

EXEMPLE I : Dépôt sur un substrat 30 en silice d'un film de verre fluoré dopé à l'erbium par un procédé ne faisant pas partie de l'invention.

Le creuset 10 contient d'une part 3 g de bain d'accueil et d'autre part 0,75 g de mélange de fluorures métalliques de base. La composition du bain d'accueil est la suivante (en mole %) : $5YF_3$ - $22BaF_2$ - $37InF_3$ - $21MnF_2$-$5LaF_3$. Le mélange des fluorures métalliques de base est le suivant (en mole %) : $30PbF_2$ - $50ZnF_2$ - $20GaF_3$. Le creuset 10 est porté à la température de 900°C.

Le creuset 20 contient 200 mg de $ErF_3$, et il est porté à une température de 1180°C.

On effectue pendant 20 minutes une coévaporation dans les conditions précitées et l'on obtient un film de composition de base 45 % $PbF_2$ - 18,5 % $ZnF_2$ - 35,5 % $GaF_3$-0,1 % $CdF_2$, dopé à 1,42 % en $ErF_3$ et d'épaisseur e = 5 µm.

Dans une autre expérience tout à fait analogue, mais avec une température du creuset 20 égale à 1140°C, l'épaisseur du film est identique, mais le taux de dopage en ErF3 est de 0,68 %.

Dans les exemples II et III suivants, les mélanges de fluorures de lanthanides ont été préalablement homogénéisés dans un tube scellé à 1200°C pendant 12 heures.

EXEMPLE II : Dépôt sur un substrat 30 en silicium d'un film de verre fluoré dopé à l'yttrium et à l'erbium.

Le creuset 10 est analogue à celui de l'exemple I (contenu et température).

Le creuset 20 contient 200 mg de mélange $YF_3$-$ErF_3$ (en proportion molaire 75/25) ; il est porté à 1180°C.

On opère dans les mêmes conditions que dans l'exemple I.

Le film obtenu a la même composition de base que dans l'exemple I ; il a une épaisseur de 5 μm et son taux de dopage est de 0,2 % en $ErF_3$ et de 1,4 % en $YF_3$.

Exemple III : dépôt sur un substrat 30 en silice d'un film de verre fluoré dopé à l'erbium et à l'ytterbium.

- Le creuset 10 est analogue à celui de l'exemple I (contenu et température)
- Le creuset 20 contient 200 mg de mélange $ErF_3$-$YbF_3$ (en proportion molaire 50/50) ; il est porté à 1180°C.

On opère dans les mêmes conditions que dans l'exemple I.

Le film obtenu a la même composition de base que dans l'exemple I ; il a une épaisseur de 5 μm et son taux de dopage est de 0,7 % en $ErF_3$ et de 0,7 % en $YbF_3$.

Exemple IV : dépôt sur un substrat 30 en verre fluoré ZBLAN d'un film en verre fluoré dopé à l'erbium.

- Le creuset 10 contient d'une part 2 g du bain d'accueil de l'exemple I et d'autre part 0,5 g du mélange des fluorures métalliques de base de l'exemple I.
- Le creuset 20 contient en mélange 0,1844 g de $ErF_3$ et 0,050 g de $ErCl_3$.

Les températures des deux creusets sont égales toutes les deux à 570°C.

On effectue une coévaporation pendant 10 minutes.

Le film obtenu a pour composition de base 34 % $PbF_2$-31 % $ZnF_2$ - 31 % $GaF_3$ - 2 % $InF_3$ - 2 % $CdF_2$ ; il a une épaisseur de 30 μm et il présente un taux de dopage en $ErF_3$ de 0,05 %.

Exemple V : dépôt sur un substrat 30 en verre fluoré ZBLAN d'un film en verre fluoré dopé au néodyme.

- Le creuset 10 est analogue à celui de l'exemple IV en ce qui concerne le contenu.
- Le creuset 20 contient en mélange 0,1825 g de $NdF_3$ et 0,050 g de $NdCl_3$.

Les températures des deux creusets sont égales toutes les deux à 550°C.

On effectue une coévaporation pendant 10 minutes.

On obtient un film de composition de base 33 % $PbF_2$-28 % $ZnF_2$ - 35 % $GaF_3$ - 2 % $InF_3$ - 2 % $CdF_2$, d'épaisseur 30 μm avec un taux de dopage en $NdF_3$ égal à 0,01 %.

EXEMPLE VI : Dépôt sur un substrat 30 en verre fluoré PB10 d'un verre fluoré dopé au praséodyme et à l'erbium.

Le creuset 10 est analogue à celui de l'exemple V en ce qui concerne le contenu et la température.

Le creuset 20 contient en mélange 0,283 g de $PrCl_3$ et 0,137 g de $ErCl_3$. Sa température est de 550°C.

On effectue une coévaporation pendant une durée de 10 minutes.

On obtient un film ayant la même composition de base que celui de l'exemple V, d'épaisseur 30 μm avec un taux de dopage de 0,07 % en $ErF_3$ et de 0,05 % en $PrF_3$.

EXEMPLE VII :

On réalise un guide d'onde 40 que l'on voit schématiquement en coupe dans la figure 2. Le substrat 30 est en verre fluoré ZBLAN.

On dépose successivement :

- un film 41 en verre fluoré d'indice optique $n_1$,
- un film 42 en verre fluoré dopé d'indice optique $n_2$,
- un film 43 analogue au film 41.

Pour cela, il est prévu de disposer dans l'évaporateur 1 un creuset supplémentaire 10' (non illustré) analogue au creuset 10.

Le creuset 10' contient un mélange de 3 g de bain d'accueil analogue à celui de l'exemple I et 0,75 g de mélange de fluorures métalliques de base contenant un mélange de $PbF_2$, $ZnF_2$ et $GaF_3$ dans des proportions molaires respectives 20 %, 50 %, 30 %. Le creuset 10 a le même contenu que celui de l'exemple I.

Le creuset 20 peut avoir, au choix, le contenu du creuset 20 des exemples II ou III.

On réalise tout d'abord le film 41 en n'utilisant que le creuset 10' à 900°C pendant 20 minutes.

La composition du film 41 obtenu est la suivante : 31 % $PbF_2$, 20 % $ZnF_2$, 48 % $GaF_3$, 0,1 à 0,5 % $CdF_2$.

On réalise ensuite le film 42 en utilisant les creusets 10 et 20, comme dans les exemples II ou III. Le verre fluoré de base a pour composition :

46 % $PbF_2$, 20 % $ZnF_2$, 33 % $GaF_3$, 0,1 à 0,5 $CdF_2$.

Le dopage en erbium, yttrium, ou ytterbium varie en fonction du contenu du creuset 20.

Les indices $n_1$ et $n_2$ sont compris entre 1,57 et 1,61.

On réalise enfin le film 43 comme le film 41.

On peut faire varier l'épaisseur des trois films en contrôlant les temps d'évaporation ; l'épaisseur des films 41 et 43 peut aller de 1 à 50 µm et plus ; celle du film 42 peut aller de 1 à 5 µm et plus.

Le procédé selon l'invention permet donc de réaliser des composants optiques intégrés qui aient à la fois la fonction de source et de guide.

Bien entendu l'invention n'est pas limitée aux modes de réalisation qui viennent d'être décrits. On pourra, sans sortir du cadre de l'invention remplacer tout moyen par un moyen équivalent.

**Revendications**

1. Procédé de dépôt en phase vapeur d'un film en verre fluoré sur un substrat, selon lequel on met en contact ledit substrat avec des flux de vapeurs des divers constituants dudit verre, lesdits flux de vapeur étant émis à partir d'un premier creuset contenant un bain d'accueil et les fluorures métalliques de base constituant ledit verre fluoré, **caractérisé par le fait que** lesdits flux de vapeur sont en outre émis de manière simultanée à partir d'un second creuset contenant des éléments dopants constitués par au moins deux halogénures dont au moins un halogénure de terres rares.

2. Procédé de dépôt selon la revendication 1, **caractérisé par le fait que** ledit second creuset contient des éléments dopants répondant à la formulation :

$$x\,YX_3 + (1-x)LnX_3$$

avec : $o < x < 1$, et

Ln = La, Ce, Pr, Nd, Pm, Sm, Eu, Gd, Tb, Dy, Ho, Er, Tm, Yb, Lu,
Y = Yttrium,
X = F ou Cl,

$LnX_3$ représentant un halogénure de terre rare ou un mélange d'halogénures de terres rares.

3. Procédé de dépôt selon l'une des revendications 1 et 2, **caractérisé par le fait que** lesdits éléments dopants se trouvent vis-à-vis desdits fluorures métalliques de base dans une proportion inférieure ou égale à 15 % en mole.

4. Procédé de dépôt selon l'une des revendications précédentes, **caractérisé par le fait que** le flux de vapeur émis par ledit premier creuset présente la composition suivante (en mole %; total 100 %) :

- 30 à 50     $PbF_2$
- 30 à 50     $GaF_3$ ou $FeF_3$ ou $CrF_3$
- 0 à 30     $ZnF_2$ ou $CuF_2$
- 1 à 5     $MnF_2$ ou $CdF_2$ ou $CoF_2$
- 1 à 5     $InF_3$
- 0 à 10     $AlF_3$
- 0 à 10     Adjuvant.

5. Procédé de dépôt selon la revencation 4, **caractérisé par le fait que** ledit creuset contient un bain d'accueil ayant la composition suivante :

- à 26     $YF_3$
- 19 à 28     $BaF_2$
- 35 à 40     $InF_3$
- 18 à 25     $MnF_2$ ou $CdF_2$ ou $ZnF_2$ ou $CoF_2$
- 0 à 10     Adjuvant.

6. Procédé de dépôt selon l'une des revendication précédentes, **caractérisé par le fait que** le matériau dudit substrat est choisi parmi un verre fluoré, l'alumine, la silice, le carbone, un métal, le silicium, un matériau semi-conducteur.

**Claims**

1. A deposition method for vapor deposition of a film of fluorine-containing glass on a substrate in which said substrate is put into contact with fluxes of the vapors of the various constituents of said glass, said vapor fluxes being emitted from a first crucible containing a host bath and main metal fluorides that constitute said fluorine-containing glass, the method being **characterized by** the fact that said vapor fluxes are also emitted simultaneously from a second crucible containing dopants constituted by at least two halides, including at least one rare earth halide.

2. A deposition method according to claim 1, **characterized by** the fact that the second crucible contains dopants satisfying the relationship:

$$xYX_3 + (1-x)LnX_3$$

where:

0<x<1;

Ln = La, Ce, Pr, Nd, Pm, Sm, Eu, Gd, Tb, Dy, Ho, Er, Tm, Yb, Lu;

Y = yttrium;

X = F or Cl; and

$LnX_3$ represents a rare earth halide or a mixture of rare earth halides.

3. A deposition method according to claim 1 or 2, **characterized by** the fact that said dopants constitute no more than 15% in moles of said main metal fluorides.

4. A deposition method according to any preceding claim, **characterized by** the fact that the vapor flux emitted by said first crucible has the following composition (in molar %; total 100%):

| | |
|---|---|
| 30 to 50 | $PbF_2$ |
| 30 to 50 | $GaF_3$ or $FeF_3$ or $CrF_3$ |
| 0 to 30 | $ZnF_2$ or $CuF_2$ |
| 1 to 5 | $MnF_2$ or $CdF_2$ or $CoF_2$ |
| 1 to 5 | $InF_3$ |
| 0 to 10 | $AlF_3$ |
| 0 to 10 | additive. |

5. A deposition method according to claim 4, **characterized by** the fact that said crucible contains a host bath having the following composition:

| | |
|---|---|
| 9 to 26 | $YF_3$ |
| 19 to 28 | $BaF_2$ |
| 35 to 40 | $InF_3$ |
| 18 to 25 | $MnF_2$ or $CdF_2$ or $ZnF_2$ or $CoF_2$ |
| 0 to 10 | additive. |

6. A deposition method according to any preceding claim, **characterized by** the fact that the material of said substrate is selected from: a fluorine-containing glass, alumina, silica, carbon, a metal, silicon, and a semiconductor material.

## Patentansprüche

1. Verfahren zum Abscheiden in der Gasphase eines Fluoridglasfilms auf ein Substrat, bei welchem das Substrat mit den Gasströmen verschiedener Komponenten des Glases in Kontakt gebracht wird, wobei die Gasströme aus einem ersten Tiegel emittiert werden, der ein Aufnahmebad und die das Fluoridglas bildenden metallischen Basisfluoride enthält, **dadurch gekennzeichnet, dass** die Gasströme zudem gleichzeitig aus einem zweiten Tiegel emittiert werden, welcher Dotierelemente enthält, die aus wenigstens zwei Halogeniden bestehen, von denen wenigstens eines ein Halogenid der Seltenen Erden ist.

2. Verfahren zum Abscheiden nach Anspruch 1, **dadurch gekennzeichnet, dass** der zweite Tiegel Dotierelemente enthält, die der Formel genügen:

$$x\, YX_3 + (1-x)LnX_3$$

mit: 0 < x < 1, und

Ln = La, Ce, Pr, Nd, Pm, Sm, Eu, Gd, Tb, Dy, Ho, Er, Tm Yb, Lu,

Y = Yttrium,

X = F oder Cl,

wobei $LnX_3$ ein Halogenid der Seltenen Erden oder eine Mischung von Halogeniden der Seltenen Erden darstellt.

3. Verfahren zum Abscheiden nach einem der Ansprüche 1 und 2, **dadurch gekennzeichnet, dass** die Dotierelemente bezogen auf die metallischen Basisfluoride in einem Anteil von kleiner oder gleich 15 Mol-% vorliegen.

4. Verfahren zum Abscheiden nach einem der vorhergehenden Ansprüche, **dadurch gekennzeichnet, dass** der von dem ersten Tiegel emittierte Gasstrom die folgende Zusammensetzung aufweist (in Mol-%; insgesamt 100%) ; 30 bis 50 $PbF_2$

30 bis 50 $GaF_3$ oder $FeF_3$ oder $CrF_3$
0 bis 30 $ZnF_2$ oder $CuF_2$
1 bis 5 $MnF_2$ oder $CdF_2$ oder $CoF_2$
1 bis 5 $InF_3$
0 bis 10 $AlF_3$
0 bis 10 Zusatzstoff.

5. Verfahren zum Abscheiden nach Anspruch 4, **dadurch gekennzeichnet, dass** der Tiegel ein Aufnahmebad der folgenden Zusammensetzung enthält:

9 bis 26 $YF_3$
19 bis 28 $BaF_2$
35 bis 40 $InF_3$
18 bis 25 $MnF_2$ oder $CdF_2$ oder $ZnF_2$ oder $CoF_2$
0 bis 10 Zusatzstoff.

6. Verfahren zum Abscheiden nach einem der vorhergehenden Ansprüche, **dadurch gekennzeichnet, dass** das Material des Substrats aus Fluoridglas, Aluminium, Silika, Kohlenstoff, einem Metall, Silizium, einem halbleitenden Material gewählt ist.

# FIG. 1

# FIG. 2